# EUROPEAN PATENT APPLICATION

(11) **EP 4 361 511 A1**
(43) Date of publication of application: **01.05.2024**
(21) Application number: 22851769.4
(22) Date of filing: 29.06.2022
(51) Int. Cl.: F24F 5/00

(54) **TEMPERATURE CONTROL METHOD AND RELATED DEVICE**

(30) Priority: 31.07.2021 CN 202110877268
(71) Applicant: Huawei Technologies Co., Ltd., Shenzhen, Guangdong 518129 (CN)
(72) Inventor: LI, Jinfeng, Shenzhen, Guangdong 518129 (CN); ZHU, Jiang, Shenzhen, Guangdong 518129 (CN); ZENG, Yongmei, Shenzhen, Guangdong 518129 (CN); YAO, Guoqiang, Shenzhen, Guangdong 518129 (CN); FANG, Liangren, Shenzhen, Guangdong 518129 (CN)
(74) Representative: Huawei European IPR
(86) International application number: PCT/CN2022/102147
(87) International publication number: WO 2023/011053

(57) **Abstract**

Embodiments of this application disclose a temperature control method and a related device, to precisely control a temperature of a device having a higher temperature control requirement in a same space, and reduce temperature control redundancy for another device in the space, so that power consumption of temperature control is reduced. The method in embodiments of this application includes: When a cooling temperature of a primary temperature control device is lower than a first preset temperature, a cold storage and temperature control device performs cold storage. When the cooling temperature of the primary temperature control device is higher than a second preset temperature, the cold storage and temperature control device performs cold discharge on a temperature-controlled device.

## Description

This application claims priority to Chinese Patent Application No. CN202110877268.3, filed with the China National Intellectual Property Administration on July 31, 2021 and entitled "TEMPERATURE CONTROL METHOD AND RELATED DEVICE", which is incorporated herein by reference in its entirety.

### TECHNICAL FIELD

Embodiments of this application relate to the field of temperature control, and in particular, to a temperature control method and a related device.

### BACKGROUND

A device has some requirements on an operating temperature. If a temperature is too high or too low, performance, service life, and the like that are of the device may be affected. Therefore, a temperature of the device needs to be controlled. For a device used indoors, a temperature control device may be used for controlling an indoor ambient temperature, to control temperatures of a plurality of devices in a same space.

However, because the plurality of devices in the same space have different temperature requirements, to meet temperature control requirements of all the devices, the indoor ambient temperature is adjusted only based on a strictest temperature requirement of the plurality of devices. For another device in the space, there is redundancy in terms of a temperature control degree. To meet the strictest temperature requirement of the device, the temperature control device also consumes more energy, and consequently energy is wasted.

For example, when a temperature needs to be lowered, and if a temperature requirement of a device A in a space is 20°C, and a temperature requirement of a device B in the space is 25°C, to meet the temperature requirement of the device A, an indoor temperature needs to be lowered to 20°C. For the device B, the ambient temperature is 5°C lower than the temperature requirement, and therefore a temperature control device wastes energy to lower a temperature in a space around the device B from 25°C to 20°C.

### SUMMARY

Embodiments of this application provide a temperature control method and a related device, to precisely control a temperature of a device having a higher temperature control requirement in a same space, and reduce temperature control redundancy for another device in the space, so that power consumption of temperature control is reduced.

According to a first aspect, an embodiment of this application provides a temperature control method. The method is applied to a cold storage and temperature control device in a target space. A primary temperature control device and a temperature-controlled device further exist in the target space. The method includes:

When a cooling temperature of the primary temperature control device is not higher than a first preset temperature, the cold storage and temperature control device performs cold storage. When the cooling temperature of the primary temperature control device is not lower than a second preset temperature, the cold storage and temperature control device performs cold discharge on the temperature-controlled device. The second preset temperature is higher than the first preset temperature.

In embodiments of this application, in a scenario in which the temperature-controlled device is cooled, and when the cooling temperature of the primary temperature control device is low, the cold storage and temperature control device stores cooling energy; and when the cooling temperature of the primary temperature control device is high, the cold storage and temperature control device releases stored cooling energy to the temperature-controlled device. When the cooling temperature of the primary temperature control device is high, the temperature-controlled device can maintain a low temperature, to meet a required temperature of the temperature-controlled device. The cooling energy is properly adjusted, so that the primary temperature control device can meet temperature requirements of all devices in the target space at a high cooling temperature, and energy consumption of the primary temperature control device can be reduced.

In an optional implementation, the target space is a communication equipment room, and the temperature-controlled device is a communication device.

In an optional implementation, the target space is a server equipment room, and the temperature-controlled device is a server.

In an optional implementation, the cold storage and temperature control device performs cold storage in a non-peak time period of power consumption, and performs cold discharge on the temperature-controlled device in a peak time period of power consumption.

In embodiments of this application, the cold storage is performed in the non-peak time period of power consumption, and the cold discharge is performed in the peak time period of power consumption, so that the primary temperature control device can implement temperature control of a device in the target space at the high cooling temperature in the peak time period of power consumption. Therefore, power consumption of the primary temperature control device is reduced in the peak time period of power consumption, and power supply pressure in the peak time period of power consumption is relieved. In other words, in the peak time period of power consumption, electricity in the non-peak time period of power consumption is used for lowering the temperature of the temperature-controlled device. From an overall view of a power grid, power consumption in the peak time period of power consumption and power consumption in the non-peak time period of power consumption are balanced. Therefore, proper adjustment of power consumption is implemented. In addition, because a unit price of electricity in the peak time period of power consumption is high, the power consumption of the primary temperature control device is reduced in the peak time period of power consumption, and temperature control costs can also be reduced.

In an optional implementation, after the cooling energy stored in the cold storage and temperature control device is released, the cold storage and temperature control device may lower the temperature of the temperature-controlled device through cooling.

In embodiments of this application, after the cooling energy stored in the cold storage and temperature control device is released, the cold storage and temperature control device lowers the temperature of the temperature-controlled device through cooling, so that the primary temperature control device does not need to lower the cooling temperature to meet a temperature requirement of the temperature-controlled device. When the cold storage and temperature control device performs cooling only for lowering the temperature of the temperature-controlled device, a temperature lowering range is small and energy consumption is low. When the primary temperature control device performs cooling for lowering an overall ambient temperature in the target space, a temperature lowering range is large and energy consumption is high. Therefore, to meet the temperature requirement of the temperature-controlled device, the cold storage and temperature control device is enabled to perform cooling. In comparison with that the primary temperature control device lowers the cooling temperature, energy consumption can be reduced.

In an optional implementation, the cold storage and temperature control device may perform cold storage or perform cold discharge based on instructions of a control device. Specifically, in the method, before that the cold storage and temperature control device performs cold storage, the cold storage and temperature control device receives first signaling from the control device, where the first signaling indicates the cold storage and temperature control device to perform cold storage; and before that the cold storage and temperature control device performs cold discharge on the temperature-controlled device, the cold storage and temperature control device receives second signaling from the temperature control device, where the second signaling indicates the cold storage and temperature control device to perform cold discharge on the temperature-controlled device.

In embodiments of this application, the cold storage and temperature control device performs cold storage or performs cold discharge based on the instructions of the control device. The control device may be further configured to manage the cooling of the primary temperature control device, and schedule the primary temperature control device and the cold storage and temperature control device based on various factors in the target space, so that precise temperature control in the target space is implemented, and energy consumption and costs needed for performing temperature control on a device in the target space are reduced.

In an optional implementation, the cold storage and temperature control device not only can be configured to perform cold storage and perform cold discharge, but also can be configured to perform heat storage and perform heat release. In the method, a secondary temperature control device further exists in the target space, and the secondary temperature control device is configured to perform heating. When a heating temperature of the secondary temperature control device is not lower than a third preset temperature, the cold storage and temperature control device performs heat storage. When the heating temperature of the secondary temperature control device is not higher than a fourth preset temperature, the cold storage and temperature control device performs heat release on the temperature-controlled device. The fourth preset temperature is lower than the third preset temperature.

In embodiments of this application, heating is also referred to as heat supply. This is not limited herein.

In embodiments of this application, in a scenario in which the temperature-controlled device is heated, and when the heating temperature of the secondary temperature control device is high, the cold storage and temperature control device stores heat energy; and when the cooling temperature of the secondary temperature control device is low, the cold storage and temperature control device releases the stored heat energy to the temperature-controlled device. When the heating temperature of the secondary temperature control device is low, the temperature-controlled device can maintain a high temperature, to meet the required temperature of the temperature-controlled device. The heat energy is properly adjusted, so that the secondary temperature control device can meet the temperature requirements of all the devices in the target space at a low heating temperature, and energy consumption of the secondary temperature control device can be reduced.

In an optional implementation, the cold storage and temperature control device performs heat storage in the non-peak time period of power consumption, and performs heat release on the temperature-controlled device in the peak time period of power consumption.

In embodiments of this application, the heat storage is performed in the non-peak time period of power consumption, and the heat release is performed in the peak time period of power consumption, so that the secondary temperature control device can implement temperature control of a device in the target space at the low heating temperature in the peak time period of power consumption. Therefore, power consumption of the secondary temperature control device is reduced in the peak time period of power consumption, and power supply pressure in the peak time period of power consumption is relieved. In other words, in the peak time period of power consumption, electricity in the non-peak time period of power consumption is used for heating the temperature-controlled device. From an overall view of a power grid, power consumption in the peak time period of power consumption and power consumption in the non-peak time period of power consumption are balanced. Therefore, proper adjustment of power consumption is implemented. In addition, because a unit price of electricity in the peak time period of power consumption is high, the power consumption of the primary temperature control device is reduced in the peak time period of power consumption, and temperature control costs can also be reduced.

In an optional implementation, after the heat energy stored in the cold storage and temperature control device is released, the cold storage and temperature control device may increase the temperature of the temperature-controlled device through heating.

In embodiments of this application, after the heat energy stored in the cold storage and temperature control device is released, the cold storage and temperature control device increases the temperature of the temperature-controlled device through heating, so that the secondary temperature control device does not need to increase the heating temperature to meet the temperature requirement of the temperature-controlled device. When the cold storage and temperature control device performs heating only for increasing the temperature of the temperature-controlled device, a heating range is small and energy consumption is low. When the secondary temperature control device performs heating for increasing an overall ambient temperature in the target space, a heating range is large and energy consumption is high. Therefore, to meet the temperature requirement of the temperature-controlled device, the cold storage and temperature control device is enabled to perform heating. In comparison with that the secondary temperature control device increases the heating temperature, energy consumption can be reduced.

In an optional implementation, the cold storage and temperature control device may perform heat storage or perform heat release based on instructions of the control device. Specifically, in the method, before that the cold storage and temperature control device performs heat storage, the cold storage and temperature control device receives third signaling from the control device, where the third signaling indicates the cold storage and temperature control device to perform heat storage; and before that the cold storage and temperature control device performs heat release on the temperature-controlled device, the cold storage and temperature control device receives fourth signaling from the temperature control device, where the fourth signaling indicates the cold storage and temperature control device to perform heat release on the temperature-controlled device.

In embodiments of this application, the cold storage and temperature control device performs heat storage or performs heat release based on the instructions of the control device. The control device may be further configured to manage the heating of the secondary temperature control device, and schedule the secondary temperature control device and the cold storage and temperature control device based on various factors in the target space, so that precise temperature control in the target space is implemented, and energy consumption and costs needed for performing temperature control on a device in the target space are reduced.

In an optional implementation, control signaling, such as the first signaling, the second signaling, the third signaling, or the fourth signaling, that is sent by the control device to the cold storage and temperature control device is determined by the control device based on at least one of the following: the peak time period of power consumption (in an area in which the primary temperature control device is located), weather, a service volume of the temperature-controlled device, an actual temperature of the temperature-controlled device, and a temperature requirement of the temperature-controlled device.

In embodiments of this application, the control device determines a working status (cold storage, cold discharge, heat storage, or heat release) of the cold storage and temperature control device based on factors such as the peak time period of power consumption and the weather, so that switching of the working status of the cold storage and temperature control device can be properly planned. For example, if the weather shows that a temperature will continue to be high in the future, same cooling energy will be released more quickly. In this case, a time period of cold storage may be prolonged to increase storage of the cooling energy, so that duration of cold discharge in the case of a high temperature can be prolonged as much as possible.

In an optional implementation, the primary temperature control device is connected to the cold storage and temperature control device through a heat tube. The cold storage and temperature control device implements heat exchange with the primary temperature control device through the heat tube, so that cooling energy from the primary temperature control device is stored.

In embodiments of this application, the primary temperature control device and the cold storage and temperature control device are connected through the heat tube. In comparison with heat exchange directly performed through air, the heat tube can improve energy transmission efficiency of the heat exchange, so that energy waste is reduced. When the primary temperature control device performs cooling at a low temperature for same duration, the cooling energy of the cold storage and temperature control device can be increased, and duration of cold discharge of the cold storage and temperature control device to the temperature-controlled device can be prolonged. When the primary temperature control device performs cooling at a same low temperature, cooling duration of the primary temperature control device can be reduced. Therefore, energy consumption is reduced.

In embodiments of this application, the cold storage and temperature control device not only can store the cooling energy of the primary temperature control device through the heat tube, to improve energy transmission efficiency in a cooling scenario and reduce energy waste, but also can store the heat energy from the secondary temperature control device through the heat tube, to improve energy transmission efficiency in a heating scenario and reduce energy waste. For beneficial effects in the heating scenario, refer to the foregoing descriptions of beneficial effects in the cooling scenario. Details are not described herein again.

In an optional embodiment, the primary temperature control device and the secondary temperature control device are a same device. For example, the primary temperature control device may be an air conditioner.

In an optional implementation, the primary temperature control device may be an air conditioner, and the secondary temperature control device may be a heating device.

According to a second aspect, an embodiment of this application provides a temperature control method. The method includes:

A control device controls a cooling temperature of a primary temperature control device to be not higher than a first preset temperature, and transmits first signaling to a cold storage and temperature control device. The first signaling indicates the cold storage and temperature control device to perform cold storage, and both the primary temperature control device and the cold storage and temperature control device are in a target space. The control device controls the cooling temperature of the primary temperature control device to be not lower than a second preset temperature, and transmits second signaling to the cold storage and temperature control device. The second signaling indicates the cold storage and temperature control device to perform cold discharge on a temperature-controlled device, and the second preset temperature is higher than the first preset temperature.

For beneficial effects of the second aspect according to embodiments of this application, refer to the first aspect. Details are not described herein again.

In an optional implementation, the target space is a communication equipment room, and the temperature-controlled device is a communication device.

In an optional implementation, the target space is a server equipment room, and the temperature-controlled device is a server.

In an optional implementation, a secondary temperature control device further exists in the target space, and a control device is configured to control heating in the target space. Specifically, in the method, the control device controls a heating temperature of the secondary temperature control device to be not lower than a third preset temperature, and transmits third signaling to the cold storage and temperature control device. The third signaling indicates the cold storage and temperature control device to perform heat storage. The control device controls the heating temperature of the secondary temperature control device to be not higher than a fourth preset temperature, and transmits fourth signaling to the cold storage and temperature control device. The fourth signaling indicates the cold storage and temperature control device to perform heat release on the temperature-controlled device, and the fourth preset temperature is lower than the third preset temperature.

In an optional implementation, the control device controls, in a non-peak time period of power consumption, the cooling temperature of the primary temperature control device to be not higher than the first preset temperature, and transmits the first signaling to the cold storage and temperature control device. The control device controls, in a peak time period of power consumption, the cooling temperature of the primary temperature control device to be not lower than the second preset temperature, and transmits the second signaling to the cold storage and temperature control device.

In an optional implementation, the secondary temperature control device further exists in the target space. The control device controls the heating temperature of the secondary temperature control device to be not lower than the third preset temperature, and transmits the third signaling to the cold storage and temperature control device. The third signaling indicates the cold storage and temperature control device to perform heat storage. The control device controls the heating temperature of the secondary temperature control device to be not higher than the fourth preset temperature, and transmits the fourth signaling to the cold storage and temperature control device. The fourth signaling indicates the cold storage and temperature control device to perform heat release on the temperature-controlled device.

In an optional implementation, control signaling, such as the first signaling, the second signaling, the third signaling, or the fourth signaling, that is sent by the control device to the cold storage and temperature control device is determined by the control device based on at least one of the following: the peak time period of power consumption (in an area in which the primary temperature control device is located), weather, a service volume of the temperature-controlled device, an actual temperature of the temperature-controlled device, and a temperature requirement of the temperature-controlled device.

According to a third aspect, an embodiment of this application provides a cold storage and temperature control device. The cold storage and temperature control device includes:
a cold storage module and a control module.

The cold storage module is configured to perform cold storage or perform cold discharge.

The control module is configured to control the cold storage module.

The cold storage and temperature control device is configured to implement the temperature control method according to the first aspect.

In an optional implementation, the cold storage and temperature control device further includes a cabinet. The cabinet is configured for disposing the temperature-controlled device shown in the first aspect.

According to a fourth aspect, an embodiment of this application provides a control device. The control device includes:
a processor and a transceiver.

The transceiver is configured to transmit signaling to a cold storage and temperature control device.

The processor is configured to obtain the signaling.

The control device is configured to implement the temperature control method according to the second aspect.

According to a fifth aspect, an embodiment of this application provides a computer-readable storage medium. The computer-readable storage medium stores a program. When a computer executes the program, the method according to the second aspect is performed.

According to a sixth aspect, an embodiment of this application provides a computer program product. When the computer program product is executed on a computer, the computer performs the method according to the second aspect.

### BRIEF DESCRIPTION OF DRAWINGS

FIG. 1 is a schematic diagram of indoor temperature control;
FIG. 2 is a schematic diagram of an application scenario of a temperature control method according to an embodiment of this application;
FIG. 3 is a schematic diagram of an architecture of a temperature control method according to an embodiment of this application;
FIG. 4 is a schematic flowchart of a temperature control method according to an embodiment of this application;
FIG. 5 is a schematic diagram of a temperature control method according to an embodiment of this application;
FIG. 6 is another schematic flowchart of a temperature control method according to an embodiment of this application;
FIG. 7 is another schematic diagram of a temperature control method according to an embodiment of this application;
FIG. 8 is a schematic diagram of a structure of a cold storage and temperature control device according to an embodiment of this application; and
FIG. 9 is a schematic diagram of a structure of a control device according to an embodiment of this application;

### DESCRIPTION OF EMBODIMENTS

Embodiments of this application provide a temperature control method and a related device, to precisely control a temperature of a device having a higher temperature control requirement in a same space, and reduce temperature control redundancy for another device in the space, so that power consumption of temperature control is reduced.

In the communication field, a function such as data transmission is implemented by a communication device. A device has a temperature requirement. If a temperature is too high or too low, performance, service life, and the like that are of the device may be affected. Therefore, temperature control needs to be performed on the device. For an indoor device, a primary temperature control device may be used for controlling an indoor ambient temperature, to control a temperature of the indoor device.

A plurality of devices in a same space may have different temperature requirements. To meet the temperature requirements of all the devices in the space, the indoor ambient temperature needs to be adjusted based on a strictest temperature requirement of the plurality of devices. For another device in the space, there is redundancy in terms of a temperature control degree. To meet the strictest temperature requirement of the device, the temperature control device also consumes more energy, and consequently, energy is wasted.

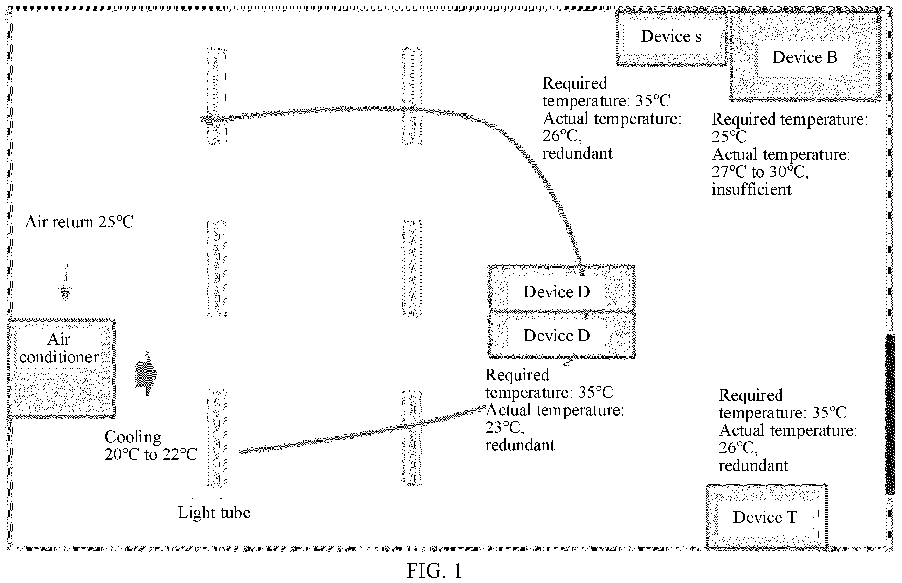

For example, as shown in FIG. 1, in a communication equipment room, temperatures of a plurality of devices are lowered by an air conditioner. A device B has a strictest temperature requirement, and the temperature requirement of the device B is 25°C. To meet the temperature requirement of the device B, a cooling temperature of the air conditioner is set to 25°C. However, a temperature requirement of another device in the equipment room does not need to be that low. Consequently, there is cooling redundancy for the another device in the equipment room.

In embodiments of this application, temperature control is mainly considered. Therefore, in embodiments of this application, impact of a temperature is mainly considered. A temperature requirement of a device may also be referred to as a requirement or a required temperature. This is not limited herein.

In addition, because the air conditioner belongs to single-point cooling, an indoor ambient temperature cannot be completely uniform. A location closer to the air conditioner has a lower temperature, and a location farther from the air conditioner has a higher temperature. As shown in FIG. 1, in the plurality of devices, an actual temperature of a device D that is close to the air conditioner is low, which is 23°C; and an actual temperature of the device B that is farthest from the air conditioner is between 27°C and 30°C. Cooling of the device B is insufficient and a cooling requirement of the device B cannot be met. If cooling for a device that is farther from the air conditioner is insufficient, performance, service life, and the like that are of the device may be affected.

To resolve the foregoing disadvantage, embodiments of this application provide a temperature control method and a related device, to implement, through a cold storage and temperature control device, single-point precise temperature control for a device having a high temperature control requirement in a space. In this way, not only can a primary temperature control device in the space meet a low temperature control requirement of another device by consuming low power, but also the single-point precise temperature control can be performed on a temperature-controlled device having a high temperature requirement, so that the temperature requirement of the temperature-controlled device is met, and performance, service life, and the like that are of the temperature-controlled device are not affected.

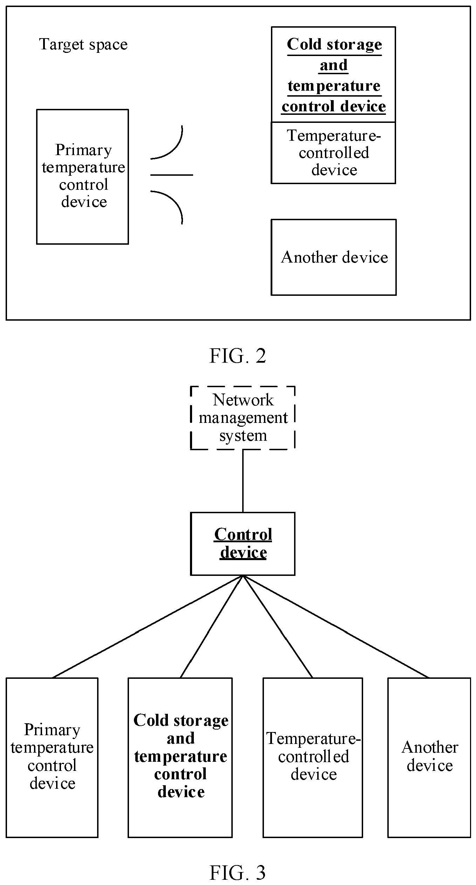

The following describes an application scenario of the temperature control method according to embodiments of this application. As shown in FIG. 2, a primary temperature control device, a temperature-controlled device, a cold storage and temperature control device, and another device exist in a target space.

The primary temperature control device is configured to control an ambient temperature of the target space, to implement temperature control of a device in the target space. For example, the primary temperature control device may control temperatures of the temperature-controlled device and the another device in the target space.

The temperature-controlled device is a device that has a high temperature requirement in the target space, and the another device is a device that has a low temperature requirement in the target space. For example, if a temperature control requirement is cooling, the temperature requirement of the another device is not higher than 35°C, and the temperature requirement of the temperature-controlled device is not higher than 25°C. Alternatively, if the temperature control requirement is heating, the temperature requirement of the another device is not lower than 10°C, and the temperature requirement of the temperature-controlled device is not lower than 15°C. This is not limited herein.

It should be noted that, the foregoing 35°C, 25°C, 10°C, and 15°C are examples of temperature requirements for different devices, and do not constitute a limitation on a temperature requirement. The temperature-controlled device and another device may alternatively have other temperature requirements, provided that when the temperature control requirement is cooling, a temperature required by the temperature-controlled device is lower than a temperature required by the another device, and when the temperature control requirement is heating, the temperature required by the temperature-controlled device is higher than the temperature required by the another device. This is not limited herein.

The cold storage and temperature control device is configured to perform cold storage or perform heat storage in a process in which the primary temperature control device performs temperature control with high power consumption, and perform cold discharge or perform heat release in a process in which the primary temperature control device performs temperature control with low power consumption, to implement precise temperature control for the temperature-controlled device and reduce power consumption of the primary temperature control device.

To ensure that the cold storage and temperature control device performs precise temperature control on the temperature-controlled device, the cold storage and temperature control device is disposed at a position close to the temperature-controlled device. For example, the cold storage and temperature control device may be next to the temperature-controlled device, or the temperature-controlled device is disposed in a cabinet in which the cold storage and temperature control device is located. This is not limited herein.

It should be noted that FIG. 2 is an example of an application scenario of a temperature control device according to embodiments of this application, and a quantity of temperature-controlled devices in the target space or a quantity of other devices in the target space is not limited. There may be more temperature-controlled devices or more other devices in the target space. This is not limited herein.

Optionally, if there are a plurality of temperature-controlled devices, there may be a plurality of cold storage and temperature control devices, or there may be one cold storage and temperature control device. This is not limited herein. If a quantity of cold storage and temperature control devices is the same as the quantity of temperature-controlled devices, the cold storage and temperature control device is configured to control a temperature of a single temperature-controlled device. Alternatively, if a quantity of cold storage and temperature control devices is less than the quantity of temperature-controlled devices, the cold storage and temperature control device is configured to control temperatures of a plurality of the temperature-controlled devices. This is not limited herein.

In embodiments of this application, the control device may schedule the primary temperature control device and the cold storage and temperature control device to perform temperature control. In an architecture shown in FIG. 3, the control device may interact with the primary temperature control device, the cold storage and temperature control device, the temperature-controlled device, and the another device in the target space, to implement temperature control for the temperature-controlled device and the another device.

Optionally, the control device may further interact with a network management system, to obtain information related to temperature control from the network management system.

In embodiments of this application, the target space may be a communication equipment room, and the temperature-controlled device and the another device are communication devices, for example, baseband processing units (baseband processing units, BBUs). In addition to the communication equipment room, the target space may be another space, for example, a server equipment room. This is not limited herein.

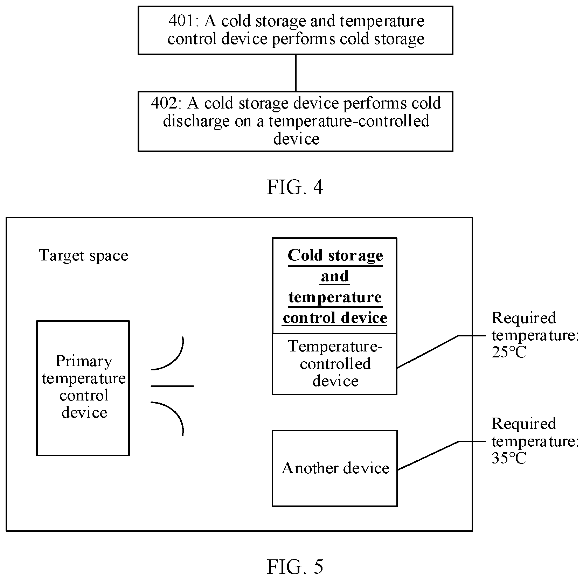

The foregoing describes the application scenario and the architecture according to embodiments of this application, and the following describes a temperature control method according to an embodiment of this application. Refer to FIG. 4. The temperature control method according to this embodiment of this application includes the following steps.

401: A cold storage and temperature control device performs cold storage.

The cold storage and temperature control device may perform cold storage. When a cooling temperature of a primary temperature control device is not higher than a first preset temperature, the cold storage and temperature control device may store cooling energy of the primary temperature control device.

The first preset temperature may be a cold storage upper limit temperature of the cold storage and temperature control device. In an environment in which a temperature is not higher than the first preset temperature, the cold storage and temperature control device may perform cold storage. For example, if a cold storage material of the cold storage and temperature control device is a phase change cold storage material, the first preset temperature may be a phase change point of the material, for example, 20°C.

FIG. 5 is used as an example. If a requirement of a temperature-controlled device is 25°C, a requirement of another device is 35°C, and the first preset temperature is the phase change point of 20°C of the phase change cold storage material in the cold storage and temperature control device, when the cooling temperature of the primary temperature control device is lower than 20°C, the cold storage and temperature control device may start to perform cold storage.

It should be noted that, in addition to the phase change cold storage material, the cold storage and temperature control device may further include another type of cold storage material, for example, a sensible heat cold storage material, a thermochemical cold storage material, an adsorption cold storage material, or the like. This is not limited herein. The first preset temperature is determined based on selection of the cold storage material. This is not limited herein.

402: The cold storage and temperature control device performs cold discharge on the temperature-controlled device.

The cold storage and temperature control device stores cooling energy in step 401, and therefore, can release the stored cooling energy to the temperature-controlled device, to lower a temperature of the temperature-controlled device. Specifically, when the cooling temperature of the primary temperature control device is not lower than a second preset temperature, the cold storage and temperature control device may perform cold discharge on the temperature-controlled device.

The second preset temperature may be the required temperature of the temperature-controlled device. To be specific, in a cooling scenario, the temperature-controlled device needs to maintain a temperature not higher than the second preset temperature; and in a heating scenario, a controlled device needs to maintain a temperature not lower than the second preset temperature. A cooling scenario in FIG. 5 is used as an example. The second preset temperature is 25°C.

The second preset temperature is higher than the first preset temperature.

The cold storage and temperature control device performs cold discharge on the temperature-controlled device, so that an actual temperature of the temperature-controlled device is lower than the required temperature of 25°C.

When an ambient temperature of the temperature-controlled device is higher than the required temperature, the cold storage and temperature control device precisely lowers the temperature of the temperature-controlled device, to ensure that the actual temperature of the temperature-controlled device meets the temperature requirement, and avoid damage to performance, service life, or the like that are of the temperature-controlled device because the temperature does not meet the requirement.

In embodiments of this application, in a scenario in which the temperature-controlled device is cooled, and when the cooling temperature of the primary temperature control device is low, the cold storage and temperature control device stores cooling energy; and when the cooling temperature of the primary temperature control device is high, the cold storage and temperature control device releases stored cooling energy to the temperature-controlled device. When the cooling temperature of the primary temperature control device is high, the temperature-controlled device can maintain a low temperature, to meet the required temperature of the temperature-controlled device. The cooling energy is properly adjusted, so that the primary temperature control device can meet temperature requirements of all devices in the target space at a high cooling temperature, and energy consumption of the primary temperature control device can be reduced.

Optionally, in this embodiment of this application, the cold storage and temperature control device may perform cold storage in a non-peak time period of power consumption, and perform cold discharge on the temperature-controlled device in a peak time period of power consumption.

In embodiments of this application, the cold storage is performed in the non-peak time period of power consumption, and the cold discharged is performed in the peak time period of power consumption, so that the primary temperature control device can implement temperature control of a device in the target space at a high cooling temperature in the peak time period of power consumption. Therefore, power consumption of the primary temperature control device is reduced in the peak time period of power consumption, and power supply pressure in the peak time period of power consumption is relieved. In other words, in the peak time period of power consumption, electricity in the non-peak time period of power consumption is used for lowering the temperature of the temperature-controlled device. From an overall view of a power grid, power consumption in the peak time period of power consumption and power consumption in the non-peak time period of power consumption are balanced. Therefore, proper adjustment of power consumption is implemented. In addition, because a unit price of electricity in the peak time period of power consumption is high, the power consumption of the primary temperature control device is reduced in the peak time period of power consumption, and temperature control costs can also be reduced.

It should be noted that, in the embodiment of FIG. 4, the cooling scenario is used as an example to describe a temperature control operation in which the cold storage and temperature control device performs single-point cooling on the temperature-controlled device. In the heating scenario, a process is similar, except that heat energy is stored and released by the cold storage and temperature control device and conditions for triggering heat storage and heat release of the cold storage and temperature control device are changed. Details are not described herein again.

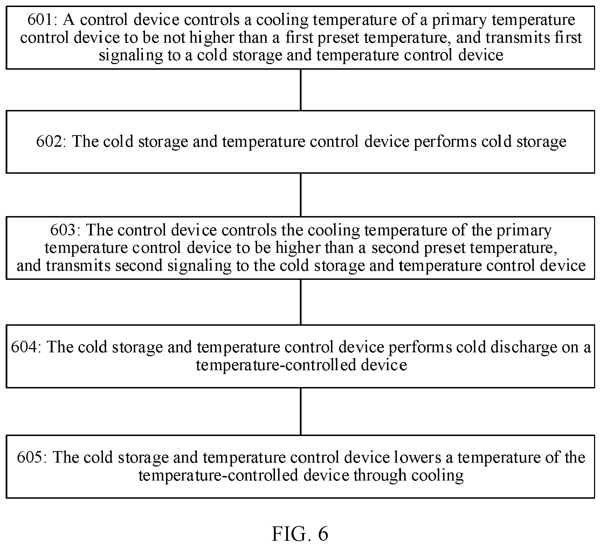

Optionally, in this embodiment of this application, a working status of the cold storage and temperature control device may be controlled by a control device. In this case, with reference to information about a device other than the cold storage and temperature control device, cold storage and cold discharge or heat storage and heat release of the cold storage and temperature control device are precisely controlled, so that an optimal energy saving effect is achieved. This embodiment is described using a cooling scenario as an example. Refer to FIG. 6. The method includes the following steps.

601: The control device controls the cooling temperature of the primary temperature control device to be not higher than the first preset temperature, and transmits first signaling to the cold storage and temperature control device.

The control device may control, in the non-peak time period of power consumption, the cooling temperature of the primary temperature control device to be not higher than the first preset temperature, and transmit the first signaling to the cold storage and temperature control device. The first signaling indicates the cold storage and temperature control device to perform cold storage.

For descriptions of the first preset temperature and the cold storage and temperature control device, refer to step 401 in embodiment shown in FIG. 4. Details are not described herein again.

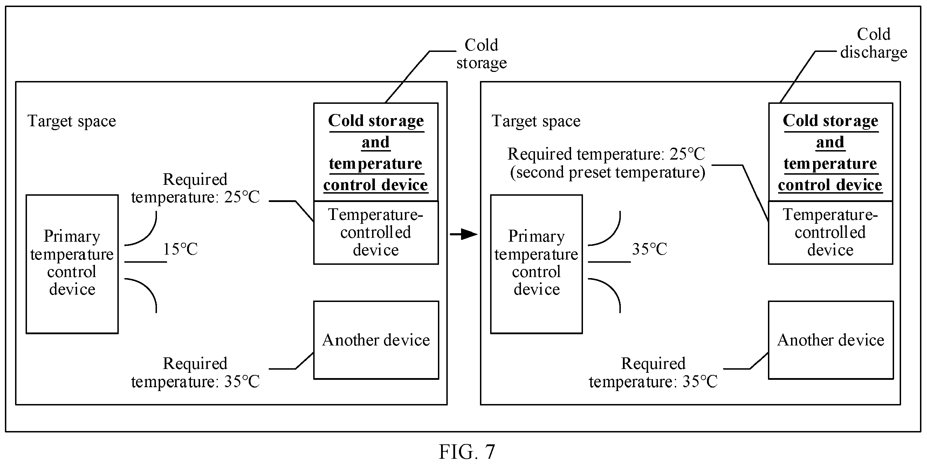

FIG. 7 is used as an example. The first preset temperature of 20°C is used as an example. The control device may control the primary temperature control device to cool the target space at a temperature of 15°C, so that all the devices in the target space are in an environment of 15°C. Requirements that the temperature of the temperature-controlled device is 25°C and a temperature of another device is 35°C are met.

Because the cooling temperature of 15°C of the primary temperature control device is lower than the first preset temperature of 20°C, the cold storage and temperature control device in the target space may perform cold storage at the temperature. Therefore, the control device transmits the first signaling to the cold storage and temperature control device, and indicates the cold storage and temperature control device to perform cold storage.

Optionally, the cold storage and temperature control device may perform cold storage based on instructions of the control device, or may perform cold storage based on another condition. For example, when it is determined, based on a detected ambient temperature around a cold storage and control device, that the ambient temperature is lower than the first preset temperature, the cold storage is started. This is not limited herein.

602: The cold storage and temperature control device performs cold storage.

For step 602, refer to step 401 in the embodiment shown in FIG. 4. Details are not described herein again.

603: The control device controls the cooling temperature of the primary temperature control device to be not lower than the second preset temperature, and transmits second signaling to the cold storage and temperature control device.

The control device may control, in the peak time period of power consumption, the cooling temperature of the primary temperature control device to be not lower than the second preset temperature, and transmit the second signaling to the cold storage and temperature control device. The second signaling indicates the cold storage and temperature control device to perform cold discharge on the temperature-controlled device.

For descriptions of the second preset temperature and the cold storage and temperature control device, refer to step 402 in the embodiment shown in FIG. 4. Details are not described herein again.

FIG. 7 is used as an example. The second preset temperature of 25°C is used as an example. The control device may control the primary temperature control device to cool the target space at a temperature of 35°C, so that all the devices in the target space are in an environment of 35°C. The requirement that the temperature of the another device is 35°C is met because the cooling temperature of the primary temperature control device is 35°C.

Because the cold storage and temperature control device stores cooling energy in step 602, when the ambient temperature around the temperature-controlled device does not meet the requirement of the temperature-controlled device, the cold storage and temperature control device may reduce the temperature of the temperature-controlled device by using the cooling energy stored in step 602, to meet the requirement of the temperature-controlled device.

Specifically, the second signaling sent by the primary temperature control device to the cold storage and temperature control device indicates the cold storage and temperature control device to perform cold discharge on the temperature-controlled device, to maintain that the temperature of the temperature-controlled device is not higher than the second preset temperature of 25°C.

Optionally, the second signaling may include information about the second preset temperature, and the temperature-controlled device controls released cooling energy based on the second preset temperature included in the second signaling, so that the temperature-controlled device meets a requirement of the second preset temperature, and excessive cooling energy is not released to cause the temperature of the temperature-controlled device to be lower than the second preset temperature. Therefore, redundancy in terms of cold discharge on the temperature-controlled device is not caused, and the cooling energy stored in the cold storage and temperature control device is not wasted.

Optionally, the cold storage and temperature control device may perform cold discharge on the temperature-controlled device based on the instructions of the control device, or may perform cold discharge based on another condition. For example, when it is determined, based on the detected ambient temperature around the cold storage and control device, that the ambient temperature is higher than the second preset temperature, the cold discharge is started. This is not limited herein.

604: The cold storage and temperature control device performs cold discharge on the temperature-controlled device.

For step 604, refer to step 402 in the embodiment shown in FIG. 4. Details are not described herein again.

605: The cold storage and temperature control device lowers the temperature of the temperature-controlled device through cooling.

Optionally, when the cooling temperature of the primary temperature control device is higher than the second preset temperature, and after the cooling energy stored in the cold storage and temperature control device is released, the cold storage and temperature control device may lower the temperature of the temperature-controlled device through cooling.

In embodiments of this application, after the cooling energy stored in the cold storage and temperature control device is released, the cold storage and temperature control device lowers the temperature of the temperature-controlled device through cooling, so that the primary temperature control device does not need to lower the cooling temperature to meet a temperature requirement of the temperature-controlled device. When the cold storage and temperature control device cools only for lowering the temperature of the temperature-controlled device, a temperature lowering range is small and energy consumption is low. When the primary temperature control device cools for lowering the overall ambient temperature in the target space, a temperature lowering range is large and energy consumption is high. Therefore, to meet the temperature requirement of the temperature-controlled device, the cold storage and temperature control device is enabled to perform cooling. In comparison with that the primary temperature control device lowers the cooling temperature, energy consumption can be reduced.

It should be noted that step 605 is an optional step. When the cooling temperature of the primary temperature control device is higher than the second preset temperature, and after the cooling energy stored in the cold storage and temperature control device is released, step 605 is performed. If the foregoing case does not occur, step 605 may not be performed. This is not limited herein.

In embodiments of this application, the cold storage is performed in the non-peak time period of power consumption, and the cold discharge is performed in the peak time period of power consumption, so that the primary temperature control device can implement temperature control of a device in the target space at a high cooling temperature in the peak time period of power consumption. Therefore, power consumption of the primary temperature control device is reduced in the peak time period of power consumption, and power supply pressure in the peak time period of power consumption is relieved. In other words, in the peak time period of power consumption, electricity in the non-peak time period of power consumption is used for lowering the temperature of the temperature-controlled device. From an overall view of a power grid, power consumption in the peak time period of power consumption and power consumption in the non-peak time period of power consumption are balanced. Therefore, proper adjustment of power consumption is implemented. In addition, because a unit price of electricity in the peak time period of power consumption is high, the power consumption of the primary temperature control device is reduced in the peak time period of power consumption, and temperature control costs can also be reduced.

Optionally, in step 601 and step 603, the control device can not only schedule the primary temperature control device and the cold storage and temperature control device based on the peak time period of power consumption and the non-peak time period of power consumption, but also can perform scheduling based on other information. For example, the scheduling is performed based on conditions such as weather, a service volume of the temperature-controlled device, and the actual temperature of the temperature-controlled device. This is not limited herein.

The weather is used as an example. The control device may obtain, from a network management system, weather of an area in which the target space is located, and adjust, based on the weather, duration in which the primary temperature control device performs cooling at the temperature lower than the first preset temperature or duration in which the primary temperature control device maintains the cooling temperature in step 401 or step 602. For example, if a temperature of the area is high, the duration in which the primary temperature control device temperature performs cooling at the temperature lower than the first preset temperature or the duration in which the primary temperature control device maintains the cooling temperature in step 401 or step 602 may be appropriately prolonged, so that the cold storage and temperature control device can store more cooling energy to cope with a high temperature.

Optionally, the primary temperature control device and the cold storage and temperature control device may be connected through a heat tube, and heat exchange between the primary temperature control device and the cold storage and temperature control device is implemented through the heat tube, to implement transmission of cooling energy or heat energy.

In embodiments of this application, the primary temperature control device and the cold storage and temperature control device are connected through the heat tube. In comparison with heat exchange directly performed through air, the heat tube can improve energy transmission efficiency of the heat exchange, so that energy waste is reduced. When the primary temperature control device performs cooling at a low temperature for same duration, the cooling energy of the cold storage and temperature control device can be increased, and duration of cold discharge of the cold storage and temperature control device to the temperature-controlled device can be prolonged. When the primary temperature control device performs cooling at a same low temperature, cooling duration of the primary temperature control device can be reduced. Therefore, energy consumption is reduced.

It should be noted that, in embodiments shown in FIG. 4 to FIG. 7, the cooling scenario is used as an example to describe the temperature control method according to embodiments of this application. In the heating scenario, the cold storage and temperature control device may also store heat energy, to implement transfer of the heat energy in terms of time. A specific procedure is similar to that in embodiments shown in FIG. 4 to FIG. 7. Details are not described herein again. In the method, in the cooling scenario, a function, a connection relationship, and the like that are of the primary temperature control device that controls the temperature by reducing the ambient temperature in the target space are replaced by those of a secondary temperature control device that controls the temperature by increasing the ambient temperature in the target space.

It should be noted that the primary temperature control device and the secondary temperature control device may be a same device, for example, an air conditioner that can perform both cooling and heating. The primary temperature control device and the secondary temperature control device may alternatively be different devices, for example, the primary temperature control device is an air conditioner, and the secondary temperature control device is a heating device. This is not limited herein.

In embodiments of this application, in step 402 shown in FIG. 4 and step 604 shown in FIG. 6, the cold storage and temperature control device implements single-point cooling on the temperature-controlled device by performing cold discharge. In the manner, the cold storage and temperature control device stores and releases the cooling energy to implement transfer of the cooling energy in terms of time, and does not need to actively perform cooling. Therefore, the manner is also referred to as passive cooling.

In step 605 shown in FIG. 6, the cold storage and temperature control device performs cooling to implement single-point temperature lowering for the temperature-controlled device, and the cold storage and temperature control device needs to actively perform cooling. Therefore, the manner is also referred to as active cooling.

The following uses the cooling scenario as an example to describe a saving effect on power and temperature control costs in the temperature control method according to embodiments of this application.

Table 1 shows comparison before and after energy saving in a case of passive cooling. As shown in Table 1, before the energy saving, an air conditioner performs cooling at a constant temperature of 25°C, and power consumption is constant over time. An electricity fee varies based on an electricity price in a time period. In a precise cooling solution provided in real time according to this application, a cooling temperature of an air conditioner (the primary temperature control device) may change with time, and the cold storage and temperature control device is used for ensuring precise temperature control for the temperature-controlled device.

For example, in Table 1, a time period corresponding to an electricity price of 1.2 CNY/kW is the peak time period of power consumption, and another time period is the non-peak time period of power consumption.

As shown in Table 1, a time period from 0:00 to 5:59 is the non-peak time period of power consumption, and an electricity price is 0.3 CNY/kW. In a time period from 0:00 to 0:59, the air conditioner performs cooling at a temperature of 35°C, generates cooling energy of 5.2 kW per hour, and consumes power of 2.08 kW per hour. The cold storage and temperature control device releases cooling energy of 0.5 kW per hour to the temperature-controlled device, to implement the single-point temperature control on the temperature-controlled device. In a time period from 1:00 to 1:59, the air conditioner performs cooling at a temperature of x°C, and the cold storage and temperature control device performs cold storage. A change rule of 2:00 to 3:59 and a change rule of 4:00 to 5:59 are the same as a change rule of 0:00 to 0:59 and a change rule of 1:00 to 1:59. Details are not described herein again. x is not higher than a cold storage upper limit temperature of the cold storage and temperature control device.

A time period from 6:00 to 7:59 is also the non-peak time period of power consumption. Power grid load in the period is higher than power grid load in the period from 1:00 to 1:59. Therefore, an electricity price is 0.7 CNY/kW, which is higher than an electricity price in the period from 1:00 to 1:59. Because the cold storage and temperature control device completes cold storage in the two time periods from 1:00 to 1:59 and from 4:00 to 5:59, in the time period from 6:00 to 7:59, the air conditioner may perform cooling at a temperature higher than or equal to 25°C, and the cold storage and temperature control device performs the single-point temperature control on the temperature-controlled device by using the stored cooling energy, to maintain the temperature of the temperature-controlled device not higher than 25°C.

A time period from 8:00 to 10:59 is the peak time period of power consumption. To reduce power grid load and save an electricity fee, the air conditioner is enabled to perform cooling at a temperature of 25°C, and the cold storage and temperature control device performs the single-point temperature control on the temperature-controlled device by using the stored cooling energy.

Change of the cooling temperature of the air conditioner from 0:00 to 10:59 and change of cold storage and cold discharge of the cold storage and temperature control device are exemplified to describe cases in the non-peak time period of power consumption and in the peak time period of power consumption. Cases after 10:59 in Table 1 are similar, and details are not described herein again.

In a time period such as 14:00 to 14:59, the air conditioner performs cooling at a temperature of x+Δ, and the cold storage and temperature control device performs cold storage. x+Δ is not higher than the cold storage upper limit temperature of the cold storage and temperature control device, and Δ is not less than 0.

It should be noted that, in the non-peak time period of power consumption shown in Table 1, the change of the cooling temperature of the air conditioner and the change of the cold storage and the cold discharge of the cold storage and temperature control device are merely examples of embodiments of this application, and do not limit the cooling temperature of the primary temperature control device in the non-peak time period of power consumption. The primary temperature control device may alternatively adjust the cooling temperature according to another rule, provided that the cold storage and temperature control device performs cold storage in the non-peak time period of power consumption. This is not limited herein.

**Table 1**

| Time period | Electricity price CNY/kW | Before energy saving | | | Precise cooling (passive cooling) | | | | |
|---|---|---|---|---|---|---|---|---|---|
| | | Original air conditioner (25°C) | | | Original air conditioner (25°C & 35°C) | | | | Cold storage and temperature control device |
| | | Cooling energy kW/h | Powe r kW/h | Electricity fee CNY/h | Cooling temperature (°C) | Cooling energy kW/h | Power kW/h | Electricity fee CNY/h | Cooling energy kW/h |
| 0:00 to 0:59 | 0.3 | 8 | 3.2 | 1.10 | 35 | 5.2 | 2.08 | 0.72 | 0.5 |
| 1:00 to 1:59 | | | | | x | 10 | 4 | 1.38 | -1.5 (cold storage) |
| 2:00 to 3:59 | | | | | 35 | 5.2 | 2.08 | 0.72 | 0.5 |
| 4:00 to 5:59 | | | | | x | 10 | 4 | 1.38 | -1.5 (cold storage) |
| 6:00 to 6:59 | 0.7 | | | 2.27 | 25 | 8 | 3.2 | 2.27 | 0 |
| 7:00 to 7:59 | | | | | 35 | 5.2 | 2.08 | 0.72 | 0.5 |
| 8:00 to 10:59 | 1.2 | | | 3.71 | 35 | 5.2 | 2.08 | 0.72 | 0.5 |
| 11:00 to 11:59 | 0.7 | | | 2.27 | x | 10 | 4 | 2.83 | -1.5 (cold storage) |
| 12:00 to 13:59 | | | | | 35 | 5.2 | 2.08 | 1.47 | 0.5 |
| 14:00 to 14:59 | | | | | x+Δ | 9 | 3.6 | 2.55 | -0.5 (cold storage) |

**Table 1 (continued)**

| Time period | Electricity price CNY/kW | Before energy saving | | | Precise cooling (passive cooling) | | | | |
|---|---|---|---|---|---|---|---|---|---|
| | | Original air conditioner (25°C) | | | Original air conditioner (25°C & 35°C) | | | | Cold storage and temperatur e control device |
| | | Cooling energy kW/h | Power kW/h | Electricit y fee CNY/h | Cooling temperature (°C) | Cooling energy kW/h | Power kW/h | Electricity fee CNY/h | Cooling energy kW/h |
| 15:00 to 15:59 | 0.7 | 8 | 3.2 | 2.27 | 35 | 5.2 | 2.08 | 1.47 | 0.5 |
| 16:00 to 16:59 | | | | | x | 10 | 4 | 2.83 | -1.5 (cold storage) |
| 17:00 to 17:59 | | | | | x+Δ | 9 | 3.6 | 2.55 | -0.5 (cold storage) |
| 18:00 to 20:59 | 1.2 | | | 3.71 | 35 | 5.2 | 2.08 | 2.41 | 0.5 |
| 21:00 to 21:59 | 0.7 | | | 2.27 | 25 | 8 | 3.2 | 2.27 | 0 |
| 22:00 to 22:59 | 0.3 | | | 1.10 | x+Δ | 10 | 4 | 1.38 | -0.5 (cold storage) |
| 23:00 to 23:59 | | | | | 35 | 5.2 | 2.08 | 0.72 | 0.5 |
| Summary (24h) | | | Power kW | Electricit y fee CNY | | | Power kW | Electricity fee CNY | |
| | | | 76.8 | 53.7 | | | 66.72 | 44.0 | |
| Relative revenue | Power | | Electricity fee | | Daily revenue (CNY) | | | Annual revenue (CNY) | |
| | 13.1% | | 18.1% | | 9.7 | | | 3541.5 | |

As shown in Table 1, in comparison with cooling at the constant temperature of 25°C, the air conditioner and the cold storage and temperature control device are scheduled according to a rule in Table 1, 13.1% of the power and 18.1% of the electricity fee are saved, 9.7 CNY of the electricity fee is saved per day, and 3541.5 CNY of the electricity fee is saved per year, so that temperature control costs are reduced.

Table 2 shows comparison before and after energy saving in a case of active cooling. As shown in Table 2, before the energy saving, the air conditioner performs cooling at the constant temperature of 25°C, generates cooling energy of 8 kW per hour, and consumes power of 3.2 kW per hour. Cooling energy and power consumption are constant over time, and an electricity fee varies based on an electricity price in a time period. In the precision cooling solution in an active mode, the air conditioner (the primary temperature control device) performs cooling at a temperature of 35°C, and generates cooling energy of 5.2 kW per hour. The cold storage and temperature control device performs active cooling, and generates cooling energy of 0.5 kW per hour. The generated cooling energy is released to the temperature-controlled device to implement the single-point temperature control on the temperature-controlled device.

Because the cold storage and temperature control device performs cooling in the target space, an equal amount of heat energy is correspondingly generated in the target space. The heat energy needs to be balanced by extra cooling energy generated by the original air conditioner, to maintain the temperature in the target space at 35°C. For the power consumption of this part, refer to additional items of the original air conditioner.

**Table 2**

| Tim e peri od | Electric ity price CNY/k W | Before energy saving | | | | Precise cooling (active mode) | | | | | | | | | | | |
|---|---|---|---|---|---|---|---|---|---|---|---|---|---|---|---|---|---|
| | | Original air conditioner (25°C) | | | | Original air conditioner (35°C) | | | | Addition of the original air conditioner | | | | Cold storage and temperature control device (active cooling) | | | |
| | | Cooli ng energ y kW/h | Pow er kW/ h | Electric ity fee CNY/h | | Cooli ng energ y kW/h | Pow er kW/ h | Electri city fee CNY/ h | | Cool ing ener gy kW/ h | Pow er kW/ h | Elect ricity fee CNY /h | | Cooli ng energ y kW/h | P o w er k W /h | Electr icity fee CNY/ h | |
| 0:0 0 to 5:5 9 | 0.3 | 8 | 3.2 | 1.10 | | 5.2 | 2.08 | 0.72 | | 0.7 | 0.28 | 0.10 | | 0.5 | 0. 2 | 0.07 | |
| 6:0 0 to 7:5 9 | 0.7 | 8 | 3.2 | 2.27 | | 5.2 | 2.08 | 1.47 | | 0.7 | 0.28 | 0.20 | | 0.5 | 0. 2 | 0.14 | |
| 8:0 0 to 10: 59 | 1.2 | 8 | 3.2 | 3.71 | | 5.2 | 2.08 | 2.41 | | 0.7 | 0.28 | 0.32 | | 0.5 | 0. 2 | 0.23 | |
| 11:0 0 to 17: 59 | 0.7 | 8 | 3.2 | 2.27 | | 5.2 | 2.08 | 1.47 | | 0.7 | 0.28 | 0.20 | | 0.5 | 0. 2 | 0.14 | |
| 18: 00 to 20: 59 | 1.2 | 8 | 3.2 | 3.71 | | 5.2 | 2.08 | 2.41 | | 0.7 | 0.28 | 0.32 | | 0.5 | 0. 2 | 0.23 | |
| 21: 00 to 21: 59 | 0.7 | 8 | 3.2 | 2.27 | | 5.2 | 2.08 | 1.47 | | 0.7 | 0.28 | 0.20 | | 0.5 | 0. 2 | 0.14 | |
| 22: 00 | 0.3 | 8 | 3.2 | 1.10 | | 5.2 | 2.08 | 0.72 | | 0.7 | 0.28 | 0.10 | | 0.5 | 0. 2 | 0.07 | |

| | | Cooli ng energ y kW/h | | Pow er kW/ h | Electric ity fee CNY/h | | Cooli ng energ y kW/h | Pow er kW/ h | Electri city fee CNY/ h | Cool ing ener gy kW/ h | | Pow er kW/ h | Elect ricity fee CNY /h | Cooli ng energ y kW/h | | P o w er k W /h | Electr icity fee CNY/ h |
|---|---|---|---|---|---|---|---|---|---|---|---|---|---|---|---|---|---|
| to 23: 59 | | | | | | | | | | | | | | | | | |
| Su mm ary (24 h) | | | | 6.8 | 3.7 | | | 49 | 35 | | | 6.7 | 4.7 | | | 4. 8 | 3.4 |

| Acti ve cool ing | Before energy saving | | | | | Precise temperature control | | | Relative revenue | | | | Electricity fee revenue | | | | |
|---|---|---|---|---|---|---|---|---|---|---|---|---|---|---|---|---|---|
| | Power | | Electricity fee | | | Power | | Electr icity fee | Power | | Electric ity fee | | Daily revenue | | Annual revenue | | |
| Su mm ary | 76.8 | | 53.7 | | | 61.44 | | 43.0 | 20.0% | | 20.0% | | 10.7 | | 3923.1 | | |

As shown in Table 2, in comparison with cooling at the constant temperature of 25°C, temperature control is performed according to a rule in Table 2, 20.0% of the power and 20.0% of the electricity fee can be saved, 10.7 CNY of the electricity fee is saved per day, and 3923.1 CNY of the electricity fee is saved per year, so that temperature control costs are reduced.

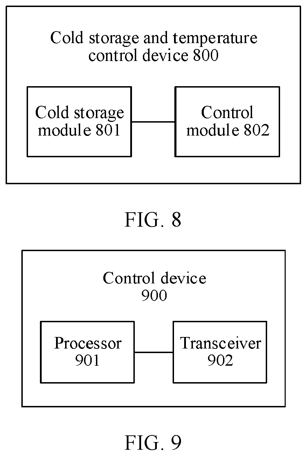

Refer to FIG. 8. An embodiment of this application further provides a cold storage and temperature control device 800. The cold storage and temperature control device 800 includes:
a cold storage module 801 and a control module 802.

The cold storage module 801 is configured to perform cold storage or perform cold discharge.

The control module 802 is configured to control the cold storage module 801.

The cold storage and temperature control device 800 is configured to implement the temperature control method according to embodiments shown in FIG. 4 to FIG. 7.

In an optional implementation, the cold storage and temperature control device may further include a cabinet. The cabinet is configured for disposing the temperature-controlled device in embodiments shown in FIG. 4 to FIG. 7.

Refer to FIG. 9. An embodiment of this application further provides a control device 900. The control device 900 includes:
a processor 901 and a transceiver 902.

The transceiver 902 is configured to transmit signaling to a cold storage and temperature control device.

The processor 901 is configured to obtain the signaling.

The control device 900 is configured to implement the temperature control method in embodiments shown in FIG. 4 to FIG. 7.

It may be clearly understood by a person skilled in the art that, for convenient and brief description, for a detailed working process of the foregoing system, apparatus, and unit, reference may be made to a corresponding process in the foregoing method embodiments, and details are not described herein again.

In the several embodiments provided in this application, it should be understood that, the disclosed system, apparatus, and method may be implemented in another manner. For example, the described apparatus embodiment is merely an example. For example, division into the units is merely logical function division and may be another division manner during actual implementation. For example, a plurality of units or components may be combined or integrated into another system, or some features may be ignored or not performed. In addition, the displayed or discussed mutual couplings or direct couplings or communication connections may be implemented through some interfaces. Indirect couplings or communication connections between the apparatuses or units may be implemented in electrical, mechanical, or other forms.

The units described as separate parts may or may not be physically separate, and parts displayed as units may or may not be physical units, may be located in one position, or may be distributed on a plurality of network units. A part or all of the units may be selected based on actual requirements to achieve the objectives of the solutions of embodiments.

In addition, all functional units in embodiments of this application may be integrated into one processing unit, or each of the units may exist alone physically, or two or more units are integrated into one unit. The integrated unit may be implemented in a form of hardware, or may be implemented in a form of a software functional unit.

When the integrated unit is implemented in a form of a software functional unit and sold or used as an independent product, the integrated unit may be stored in a computer-readable storage medium. Based on such an understanding, the technical solutions of this application essentially, or the part contributing to the conventional technology, or all or a part of the technical solutions may be implemented in a form of a software product. The computer software product is stored in a storage medium and includes several instructions for instructing a computer device (which may be a personal computer, a server, a network device, or the like) to perform all or a part of the steps of the method in embodiments of this application. The foregoing storage medium includes: any medium, such as a USB flash drive, a removable hard disk, a read-only memory (ROM, read-only memory), a random access memory (RAM, random access memory), a magnetic disk, or an optical disc, that can store program code.

## Claims

1. A temperature control method, wherein the method is applied to a cold storage and temperature control device in a target space, a primary temperature control device and a temperature-controlled device further exist in the target space, and the method comprises:
when a cooling temperature of the primary temperature control device is not higher than a first preset temperature, performing, by the cold storage and temperature control device, cold storage; and
when the cooling temperature of the primary temperature control device is not lower than a second preset temperature, performing, by the cold storage and temperature control device, cold discharge on the temperature-controlled device, wherein the second preset temperature is higher than the first preset temperature.

2. The method according to claim 1, wherein
the performing, by the cold storage and temperature control device, cold storage comprises:
performing, by the cold storage and temperature control device, cold storage in a non-peak time period of power consumption; and
the performing, by the cold storage and temperature control device, cold discharge on the temperature-controlled device comprises:
performing, by the cold storage and temperature control device, cold discharge on the temperature-controlled device in a peak time period of power consumption.

3. The method according to claim 1 or 2, wherein after the performing, by the cold storage and temperature control device, cold discharge on the temperature-controlled device, the method further comprises:
lowering, by the cold storage and temperature control device, a temperature of the temperature-controlled device through cooling.

4. The method according to any one of claims 1 to 3, wherein
before the performing, by the cold storage and temperature control device, cold storage, the method further comprises:
receiving, by the cold storage and temperature control device, first signaling from a control device, wherein the first signaling indicates the cold storage and temperature control device to perform cold storage; and
before the performing, by the cold storage and temperature control device, cold discharge on the temperature-controlled device, the method further comprises:
receiving, by the cold storage and temperature control device, second signaling from the control device, wherein the second signaling indicates the cold storage and temperature control device to perform cold discharge on the temperature-controlled device.

5. The method according to any one of claims 1 to 4, wherein a secondary temperature control device further exists in the target space, and the method further comprises:
when a heating temperature of the secondary temperature control device is not lower than a third preset temperature, performing, by the cold storage and temperature control device, heat storage; and
when the heating temperature of the secondary temperature control device is not higher than a fourth preset temperature, performing, by the cold storage and temperature control device, heat release on the temperature-controlled device, wherein the fourth preset temperature is lower than the third preset temperature.

6. The method according to claim 5, wherein
the performing by the cold storage and temperature control device, heat storage comprises:
performing, by the cold storage and temperature control device, heat storage in the non-peak time period of power consumption; and
the performing, by the cold storage and temperature control device, heat release on the temperature-controlled device comprises:
performing, by the cold storage and temperature control device, heat release on the temperature-controlled device in the peak time period of power consumption.

7. The method according to claim 5 or 6, wherein after the performing, by the cold storage and temperature control device, heat release on the temperature-controlled device, the method further comprises:
increasing, by the cold storage and temperature control device, the temperature of the temperature-controlled device through heating.

8. The method according to any one of claims 5 to 7, wherein
before the performing, by the cold storage and temperature control device, heat storage, the method further comprises:
receiving, by the cold storage and temperature control device, third signaling from the control device, wherein the third signaling indicates the cold storage and temperature control device to perform heat release on the temperature-controlled device; and
before the performing, by the cold storage and temperature control device, heat release on the temperature-controlled device, the method further comprises:
receiving, by the cold storage and temperature control device, fourth signaling from the control device, wherein the fourth signaling indicates the cold storage and temperature control device to perform heat release on the temperature-controlled device.

9. The method according to any one of claims 4 to 8, wherein at least one of the first signaling, the second signaling, the third signaling, and the fourth signaling is determined by the control device based on at least one of the following:
the peak time period of power consumption;
weather;
a service volume of the temperature-controlled device;
an actual temperature of the temperature-controlled device; and
a temperature requirement of the temperature-controlled device.

10. The method according to any one of claims 1 to 9, wherein the primary temperature control device is connected to the cold storage and temperature control device through a heat tube; and
the performing, by the cold storage and temperature control device, cold storage comprises:
storing, by the cold storage and temperature control device, cooling energy from the primary temperature control device through the heat tube.

11. The method according to any one of claims 5 to 10, wherein the primary temperature control device and the secondary temperature control device are a same device.

12. A temperature control method, comprising:
controlling, by a control device, a cooling temperature of a primary temperature control device to be not higher than a first preset temperature, and transmitting first signaling to a cold storage and temperature control device, wherein the first signaling indicates the cold storage and temperature control device to perform cold storage, and both the primary temperature control device and the cold storage and temperature control device are in a target space; and
controlling, by the control device, the cooling temperature of the primary temperature control device to be not lower than a second preset temperature, and transmitting second signaling to the cold storage and temperature control device, wherein the second signaling indicates the cold storage and temperature control device to perform cold discharge on a temperature-controlled device, and the second preset temperature is higher than the first preset temperature.

13. The method according to claim 12, wherein
the controlling, by a control device, a cooling temperature of a primary temperature control device to be not higher than a first preset temperature, and transmitting first signaling to a cold storage and temperature control device comprise:
controlling, by the control device in a non-peak time period of power consumption, the cooling temperature of the primary temperature control device to be not higher than the first preset temperature, and transmitting the first signaling to the cold storage and temperature control device; and
the controlling, by the control device, the cooling temperature of the primary temperature control device to be not lower than a second preset temperature, and transmitting second signaling to the cold storage and temperature control device comprise:
controlling, by the control device in a peak time period of power consumption, the cooling temperature of the primary temperature control device to be higher than the second preset temperature, and transmitting the second signaling to the cold storage and temperature control device.

14. The method according to claim 12 or 13, wherein a secondary temperature control device further exists in the target space, and the method further comprises:
controlling, by the control device, a heating temperature of the secondary temperature control device to be not lower than a third preset temperature, and transmitting third signaling to the cold storage and temperature control device, wherein the third signaling indicates the cold storage and temperature control device to perform heat storage; and
controlling, by the control device, the heating temperature of the secondary temperature control device to be not higher than a fourth preset temperature, and transmitting fourth signaling to the cold storage and temperature control device, wherein the fourth signaling indicates the cold storage and temperature control device to perform heat release on the temperature-controlled device, and the fourth preset temperature is lower than the third preset temperature.

15. The method according to any one of claims 12 to 14, wherein at least one of the first signaling, the second signaling, the third signaling, and the fourth signaling is determined by the control device based on at least one of the following:
weather;
a service volume of the temperature-controlled device;
an actual temperature of the temperature-controlled device; and
a temperature requirement of the temperature-controlled device.

16. A cold storage and temperature control device, wherein the cold storage and temperature control device comprises:
a cold storage module and a control module, wherein
the cold storage module is configured to perform cold storage or perform cold discharge;
the control module is configured to control the cold storage module; and
the cold storage and temperature control device is configured to implement the temperature control method according to any one of claims 1 to 11.

17. The cold storage and temperature control device according to claim 16, wherein the cold storage and temperature control device further comprises a cabinet, wherein
the cabinet is configured for disposing the temperature-controlled device according to any one of claims 1 to 11.

18. A control device, wherein the control device comprises:
a processor and a transceiver, wherein
the transceiver is configured to transmit signaling to a cold storage and temperature control device;
the processor is configured to obtain the signaling; and
the control device is configured to implement the temperature control method according to any one of claims 12 to 15.

19. A computer-readable storage medium, wherein the computer-readable storage medium stores a program; and when a computer executes the program, the method according to any one of claims 12 to 15 is performed.

20. A computer program product, wherein when the computer program product is executed on a computer, the computer performs the method according to any one of claims 12 to 15.
